# EUROPÄISCHE PATENTSCHRIFT

(11) **EP 3 213 016 B1**
(45) Veröffentlichungstag und Bekanntmachung des Hinweises auf die Patenterteilung: **06.12.2023**
(21) Anmeldenummer: 15774928.4
(22) Anmeldetag: 06.10.2015
(51) Int. Cl.: F25D 27/00

(54) **HAUSHALTSGERÄT MIT EINER EINGABEVORRICHTUNG UND EINER KODIERVORRICHTUNG**
DOMESTIC APPLIANCE COMPRISING AN INPUT DEVICE AND A CODING DEVICE
APPAREIL MÉNAGER COMPORTANT UN DISPOSITIF D'ENTRÉE ET UN SYSTÈME DE CODAGE

(30) Priorität: 27.10.2014 DE 102014221784
(43) Veröffentlichungstag der Anmeldung: 06.09.2017
(73) Patentinhaber: BSH Hausgeräte GmbH, 81739 München (DE)
(72) Erfinder: KIBAT, Jörg, 92431 Neunburg vorm Wald (DE); HAUZENEDER, Christoph, 94164 Sonnen (DE); HOFMEISTER,Bernhard, 92331 Parsberg (DE)
(86) Internationale Anmeldenummer: PCT/EP2015/073013
(87) Internationale Veröffentlichungsnummer: WO 2016/066381

(56) Entgegenhaltungen:
- EP-A1- 2 141 722
- WO-A1-2009/068518
- WO-A1-2010/029042
- JP-A- 2013 057 432
- US-A1- 2005 002 170
- US-B2- 7 878 009

## Beschreibung

Die Erfindung betrifft eine Bedien- und Anzeigevorrichtung, sowie ein Haushaltsgerät in Form eines Kältegeräts, aufweisend eine solche Bedien- und Anzeigevorrichtung.

Die DE 10 2012 223 779 A1 beschreibt ein Haushaltsgerät mit einer Steuereinrichtung, einer mindestens teilweise lichtdurchlässigen Blende sowie mit einem mindestens teilweise lichtdurchlässigen Bedienpanel mit mindestens einem kapazitiven Sensor zur Auswahl einer Programmfunktion des Haushaltsgerätes durch einen Benutzer des Gerätes, wobei das Bedienpanel ein aus mehreren Schichten bestehendes Kunststoffbauteil aufweist, umfassend eine Anzeigedisplayfolie; eine berührungsempfindliche Folie, welche den mindestens einen kapazitiven Sensor sowie elektrische Leiterbahnen aufweist; und eine strukturierte Lichtleiterschicht; wobei das Kunststoffbauteil erhältlich ist durch Verbinden einer selbstklebenden Anzeigedisplayfolie mit der berührungsempfindlichen Folie und ein anschließendes Hinterspritzen der strukturierten Lichtleiterschicht.

Die JP 2013057432 A beschreibt ein Kältegerät mit einer Frontblende an der Kältegerätetür und mit einem Eingabebereich und einem Anzeigebereich. Zwischen einer Anzeigeeinheit und der Frontblende ist ein Rahmen eingefügt, an dem ein Lichtführungsbauteil und eine separate Eingabevorrichtung angebracht sind. Die Anzeigeeinheit ist mittels sechs gleichmäßig beabstandet angeordneter Rasthaken an dem Rahmen befestigt.

Die WO 2010/029042 A1 beschreibt ein Haushaltsgerät, das eine an der Tür angebrachte Steuervorrichtung umfasst, das hinter einer Glasplatte der Tür angebracht ist. Dazu ist ein Rahmen vorgesehen, der einerseits an der Rückseite der Glasplatte angeklebt ist und an dem andererseits die Steuervorrichtung eingesetzt und von einem Deckel verschlossen ist.

Die EP 2 141 722 A1 befasst sich mit einem Ziffernblock für ein Mobiltelefon, ein PDA, tragbare Audiogeräte und Fernsteuerungen.

Die US 7,878,009 B2 offenbart ein Kältegerät mit einer Bedien- und Anzeigeeinheit, die eine Frontblende aufweist, hinter der unter anderem ein Lichtführungsbauteil angeordnet ist, das an einem Steuergehäuse befestigt ist. Ein Rahmen der Lichtführungsbauteile ist mittels Laschen rückseitig an dem Steuergehäuse angeschraubt.

Die WO 2009/068518 A1 beschreibt ein Lichtführungsbauteil, das mittels zweier gegenüberliegender, jeweils genau zentral mittig angeordneter Laschen an dem Rahmen befestigt ist.

Die US 2005002170 A1 beschreibt eine allgemein bekannte Fernsteuervorrichtung mit einem Ziffernblock. Das dortige Lichtführungsbauteil ist passgenau zu dem Tastenblock ausgeführt, wobei die einzelnen Tasten des Tastenblocks eine entsprechend identische Anzahl von gleichkonturierten Durchbrüchen des Lichtführungsbauteils durchdingen.

Die Aufgabe der Erfindung ist es, eine Bedien- und Anzeigevorrichtung zu schaffen, die auf einfache und sichere Weise montiert werden kann.

Die Aufgabe der Erfindung wird gelöst durch eine Bedien- und Anzeigevorrichtung gemäß Anspruch 1, die für ein Kältegerät vorgesehen ist. insbesondere weist sie auf:
- eine Bedienblende, welche mehrere Betätigungs- und/oder Anzeigefelder einer spezifischen Ausführungsart aus wenigstens zwei verschiedenen Ausführungsarten aufweist,
- eine Eingabevorrichtung, die mehrere der spezifischen Ausführungsart der Bedienblende angepasste, den Betätigungsfeldern zugeordnete Eingabemittel aufweist,
- eine elektronische Steuervorrichtung, die ausgebildet ist, wenigstens eine Funktion des Kältegeräts zu steuern und die eine elektronische Steuerplatine aufweist, die wenigstens ein lichtaussendendes elektrisches Bauteil trägt und die ausgebildet ist, basierend auf einer manuellen Betätigung des jeweiligen Betätigungsfeldes der Bedienblende mittels des zugeordneten Eingabemittels der Eingabevorrichtung ein entsprechendes Steuersignal zum Ansteuern der Funktion des Kältegeräts zu erzeugen,
- ein Lichtführungsbauteil, das die Eingabevorrichtung trägt und das der spezifischen Ausführungsart von Betätigungs- und/oder Anzeigefeldern der Bedienblende entsprechend ausgebildet ist, das von dem wenigstens einen lichtaussendenden elektrischen Bauteil ausgesendete Licht im Bereich wenigstens eines der Anzeigefelder der Bedienblende an eine Rückseite der Eingabevorrichtung zu leiten, und
- einen Befestigungsrahmen, der ausgebildet ist, wahlweise das Lichtführungsbauteil der einen Ausführungsart oder der anderen Ausführungsart an einer Rückseite der Bedienblende zu befestigen, derart, dass die Eingabevorrichtung der spezifischen Ausführungsart von Betätigungs- und/oder Anzeigefeldern der Bedienblende entsprechend an die Bedienblende angekoppelt ist, des Weiteren aufweisend eine Kodiervorrichtung, die ausgebildet ist, eine Montage des Lichtführungsbauteils einer ersten Ausführungsart nur in einer ersten Montageposition am Befestigungsrahmen zuzulassen und eine Montage des Lichtführungsbauteils einer zweiten Ausführungsart nur in einer von der ersten Montageposition abweichenden zweiten Montageposition am Befestigungsrahmen zuzulassen.

Zur Reduzierung von Herstellkosten in der Fertigung von Großserienprodukten, wie Haushaltsgeräten, ist es zweckmäßig die Teilevielfalt zu reduzieren, insbesondere möglichst viele Gleichteile auch für unterschiedliche Gerätearten, unterschiedliche Markentypen von Geräten und/oder unterschiedliche Modelle derselben Geräteart zu verwenden. Im vorliegenden Falle sollen Lichtführungsbauteile, Eingabevorrichtungen und Steuerplatinen zu einer Baueinheit zusammengebaut, insbesondere vormontiert werden. Für unterschiedliche Gerätearten, unterschiedliche Markentypen von Geräten und/oder unterschiedliche Modelle derselben Geräteart sollen die Eingabemittel, die Steuerplatinen und/oder zugeordnete Lichtschächte am Lichtführungsbauteil in verschiedenen Ausführungsarten verbaut werden, wobei sowohl das Eingabemittel, die Steuerplatine und das Lichtführungsbauteil gleiche Außengestalt aufweisen können bzw. aufweisen sollen. Dies kann bedeuten, dass beispielsweise die Steuerplatinen für verschiedene Gerätearten, Markentypen und/oder Modellen identisch hinsichtlich ihrer Außenkontur und Abmaße sind, jedoch unterschiedliche Bestückungen mit elektronischen Bauteilen aufweisen können und/oder elektronische programmierbare Prozessoren und/oder Speicher unterschiedlich programmiert sein können, selbst wenn die Steuerplatine sogar identisch mit elektronischen Bauteilen bestückt ist. Dieser Unterschied ist jedoch für einen Monteur nicht immer so einfach erkennbar. Um Verwechslungen zu vermeiden, ist erfindungsgemäß die Kodiervorrichtung vorgesehen, die ausgebildet ist, eine Montage des Eingabemittels, welches aus mehreren verschiedenen Eingabemitteln gleicher Gestalt, jedoch unterschiedlicher Ausführungsart ausgewählt ist, und/oder eine Montage der Steuerplatine, welche aus mehreren verschiedenen Steuerplatinen gleicher Gestalt, jedoch unterschiedlicher Ausführungsart ausgewählt ist, nur dann zuzulassen, wenn das ausgewählte Eingabemittel bzw. die ausgewählte Steuerplatine in seiner Ausführungsart der spezifischen Ausführungsart des Lichtführungsbauteils zugehörig ist. Das Lichtführungsbauteil weist einen oder mehrere Lichtschächte auf, wobei jeder Lichtschacht eine lichtundurchlässige Mantelwand aufweist, an einer Stirnseite eine Lichteintrittsöffnung für das von einem Licht aussendenden Bauteil auf der Steuerplatine ausgesendete Licht. Und auf einer gegenüberliegenden Seite eine Lichtaustrittsöffnung aufweist, aus welcher das Licht austritt, um ein Betätigungs- und/oder Anzeigefeld der Bedienblende zu hinterleuchten.

Unterschiedliche Ausführungsarten von Eingabemitteln der Bedienblende können beispielsweise eine unterschiedliche Anzahl von Eingabemitteln sein, aber auch die Formen der einzelnen Eingabemitteln oder deren Anordnung und Gruppierung können unterschiedlich sein. Eine gleiche Gestalt des Eingabemittels kann beispielsweise dann gegeben sein, wenn die Eingabemittel Touch-Folien sind, und die Touch-Folien unterschiedlicher Ausführungsart zwar verschiedene Anzahlen und/oder Anordnungen von Tastflächen aufweist, die Touch-Folien dabei jedoch dieselben Außenabmessungen bzw. Konturen aufweisen. In einem noch nicht montierten, insbesondere noch nicht elektrisch angeschlossenen Zustand können diese Touch-Folien unterschiedlicher Ausführungsart jedoch für einen Monteur nicht immer einfach durch Augenschein unterschieden werden.

Unterschiedliche Ausführungsarten von Steuerplatinen können sich, wie erwähnt, durch eine unterschiedliche Bestückung mit elektronischen Bauteilen und/oder durch elektronische unterschiedlich programmierte Prozessoren und/oder Speicher gebildet werden. Eine gleiche Gestalt von Steuerplatinen unterschiedlicher Ausführungsarten kann beispielsweise vorliegen, wenn die Steuerplatinen unterschiedlicher Ausführungsarten dieselben Außenabmessungen bzw. Konturen aufweisen. Die Steuerplatinen unterschiedlicher Ausführungsarten können wie bereits erwähnt für einen Monteur nicht immer einfach durch Augenschein unterschieden werden. Unterschiedliche Ausführungsarten von Steuerplatinen und/oder Eingabevorrichtungen können sich auch dann ergeben, wenn die Steuerplatinen bzw. die Eingabevorrichtungen zwar weitgehend gleich oder zumindest ähnlich bestück bzw. gestaltet sind, aber sich beispielsweise durch eine die Steuerplatine mit der Eingabevorrichtung verbindende elektrische Anschlussleitung, insbesondere ein Flachbandanschlusskabel unterscheiden. Die unterschiedlichen Ausführungsarten von Anschlussleitungen bzw. Flachbandanschlusskabel können beispielsweise unterschiedliche Anzahlen von Einzeldrähten aufweisen und/oder in ihren Kabelabmessungen unterschiedlich breit sein, insbesondere auch unterschiedliche Anschlussstecker aufweisen, mit denen sie an die Steuerplatine elektrisch angeschlossen sind.

Die Bedien- und Anzeigevorrichtung weist erfindungsgemäß eine Kodiervorrichtung auf, die ausgebildet ist, eine Montage des Lichtführungsbauteils einer ersten Ausführungsart nur in einer ersten Montageposition am Befestigungsrahmen zuzulassen und eine Montage des Lichtführungsbauteils einer zweiten Ausführungsart nur in einer von der ersten Montageposition abweichenden zweiten Montageposition am Befestigungsrahmen zuzulassen.

Demgemäß ist vorgesehen, dass die Kodiervorrichtung nur dann eine Montage zulässt, wenn das ausgewählte Eingabemittel bzw. die ausgewählte Steuerplatine in seiner Ausführungsart der spezifischen Ausführungsart des Lichtführungsbauteils zugehörig ist. Die bedeutet, dass das Eingabemittel bzw. die Steuerplatine und das Lichtführungsbauteil funktional aufeinander abgestimmt sein müssen, damit sie überhaupt bestimmungsgemäß funktionieren montiert werden können. Dies bedeutet, dass das das für die Montage ausgewählte Eingabemittel und/oder die ausgewählte Steuerplatine der spezifischen Ausführungsart, d.h. dem funktional auf das Eingabemittel und/oder auf die ausgewählte Steuerplatine abgestimmte Leichtleiterbauteil, zugehörig sein muss. Die erfindungsgemäße Kodiervorrichtung verhindert die Montage eines nicht passenden Eingabemittels bzw. einer nicht passenden Steuerplatine, indem sie es verhindert, dass ein Monteur die genannten Komponenten an falscher Stelle montieren kann. Nur wenn das Eingabemittels und/oder die Steuerplatine zu dem Lichtführungsbauteil funktional passen und an der richtigen Position angesetzt werden, lassen sich diese Komponenten trotz vorhandener Kodiervorrichtung richtig montieren.

Die Kodiervorrichtung kann auch eine mechanische Kodiervorrichtung sein, welche mindestens ein Kodierglied und mindestens ein zugeordnetes Gegenkodierglied aufweist, das an dem funktional der spezifischen Ausführungsart des Lichtführungsbauteils entsprechenden Eingabemittel bzw. an dem funktional der spezifischen Ausführungsart des Lichtführungsbauteils entsprechenden Steuerplatine angeordnet ist.

Die Kodiervorrichtung kann eine mechanische Kodiervorrichtung sein, welche wenigstens ein am Lichtführungsbauteil ausgebildetes Kodierglied und wenigstens ein zugeordnetes, an dem Befestigungsrahmen ausgebildetes Gegenkodierglied aufweist, wobei die Anzahl, Größe, Form und/oder Position des wenigstens einen Kodierglieds und des wenigstens einen Gegenkodierglieds ausgebildet sind, eine Montage des Lichtführungsbauteils der ersten Ausführungsart nur in der ersten Montageposition am Befestigungsrahmen zuzulassen und eine Montage des Lichtführungsbauteils der zweiten Ausführungsart nur in der von der ersten Montageposition abweichenden zweiten Montageposition am Befestigungsrahmen zuzulassen.

Die Kodiervorrichtung kann mindestens ein formschlüssig wirkendes Kodiermittel aufweisen, insbesondere kann das Kodierglied von wenigstens einem Vorsprung und das Gegenkodierglied von wenigstens einer den Vorsprung in der Montageposition aufnehmenden Aussparung gebildet werden. Das Kodierglied und das mindestens eine zugeordnete Gegenkodierglied können dabei ausgebildet sein, optisch einem Monteur die jeweilige Zugehörigkeit anzuzeigen. Dies kann beispielsweise durch eine aufeinander abgestimmte Gestalt, Form, Farbe, Anzahl von Merkmalen, wie Vorsprüngen oder Aussparungen dem Monteur angezeigt werden.

Das formschlüssig wirkende Kodiermittel kann demgemäß beispielsweise durch wenigstens einen Vorsprung und wenigstens einer entsprechenden Aussparung gebildet werden. Die Kodiervorrichtung kann danach derart ausgebildet sein, dass Vorsprung und Aussparung in der korrekten Montageposition der funktional zugehörigen Bauteile von Eingabemittel, Steuerplatine und Lichtführungsbauteil formschlüssig ineinandergreifen. Funktional nicht zugehörige Bauteile von Eingabemittel, Steuerplatine und Lichtführungsbauteil würden andererseits formschlüssig nicht ineinandergreifen können, insbesondere die demgemäß falsch angeordneten bzw. falsch ausgebildeten Vorsprünge würden gegen nichtausgesparte Flächen von Eingabemittel, Steuerplatine und/oder Lichtführungsbauteil stoßen und dadurch eine Montage verhindern.

Das Eingabemittel und/oder die Steuerplatine können wenigstens eine Aussparung aufweisen und die Kodierung kann durch die Form der Aussparung, der Anzahl der Aussparungen und/oder durch die Position der wenigstens einen Aussparung an dem Lichtführungsbauteil dargestellt sein.

Das Lichtführungsbauteil kann den wenigstens einen Vorsprung aufweisen und die Kodierung kann durch die Form des Vorsprungs, der Anzahl der Vorsprünge und/oder durch die Position des wenigstens einen Vorsprungs an dem Lichtführungsbauteil dargestellt sein.

Der Befestigungsrahmen kann an einer Rückseite der Bedienblende befestigt sein, insbesondere als Kunststoffspritzgussteil einteilig mit einer aus Kunststoff hergestellten Bedienblende ausgebildet sein.

Die Bedienblende kann eine Glasfront aufweisen und der Befestigungsrahmen als ein separates Bauteil an einer Rückseite der Glasfront der Bedienblende befestigt sein.

Das Lichtführungsbauteil kann ein oder mehrere Lichtschächte aufweisen, die der spezifischen Ausführungsart entsprechend in Anzahl, Größe, Form und/oder Position an dem Lichtführungsbauteil angeordnet sind. Das Lichtführungsbauteil kann einen oder mehrere Lichtschächte aufweisen, wobei jeder Lichtschacht eine lichtundurchlässige Mantelwand aufweist, an einer Stirnseite eine Lichteintrittsöffnung für das von einem Licht aussendenden Bauteil auf der Steuerplatine ausgesendete Licht. Und auf einer gegenüberliegenden Seite eine Lichtaustrittsöffnung aufweist, aus welcher das Licht austritt, um ein Betätigungs- und/oder Anzeigefeld der Bedienblende zu hinterleuchten.

Das Lichtführungsbauteil können dabei ein oder mehrere Lichtschächte aufweisen, die ausgebildet sein können, das aus wenigstens einem lichtaussendenden elektrischen Bauteil, beispielsweise wenigstens einer LED, insbesondere einer auf der elektronischen Steuerplatine bestückten LED ausgesendete Licht an eine Rückseite des flexiblen Trägers zu leiten. Die Halteeinrichtung bzw. das Lichtführungsbauteil kann demgemäß aus einem Kunststoffbauteil, insbesondere Kunststoffspritzgussbauteil hergestellt sein. Neben den insoweit an der Halteeinrichtung angeformten Lichtschächte können weitere, auch separate Lichtleiterkörper vorgesehen sein.

Das Lichtführungsbauteil kann erste Haltemittel aufweisen, insbesondere erste Rasthaken umfassende erste Haltmittel aufweisen, die ausgebildet sind, die elektronische Steuerplatine formschlüssig und/oder kraftschlüssig an dem Lichtführungsbauteil wahlweise in der ersten Montageposition oder in der zweiten Montageposition zu befestigen.

Das Lichtführungsbauteil kann erste Haltemittel aufweisen, insbesondere erste Rasthaken umfassende erste Haltmittel aufweisen, die ausgebildet sind, die elektronische Steuerplatine formschlüssig und/oder kraftschlüssig an dem Lichtführungsbauteil zu befestigen.

Jedes erste Haltemittel kann von einem ersten Rasthaken gebildet werden. Jeder Rasthaken kann einteilig mit dem Lichtführungsbauteil ausgebildet sein und einen federnden Schaftabschnitt und eine am freien Ende des federnden Schaftabschnitts angeordnete Rastnase umfassen. In einem zusammengebauten Zustand umgreifen in einer solchen Ausführung die Rasthaken, insbesondere die Rastnasen die zugeordneten Randabschnitte der elektronischen Leiterplatte formschlüssig. Insoweit kann die elektronische Leiterplatte an das Lichtführungsbauteil angerastet werden.

Der Befestigungsrahmen kann zweite Haltemittel aufweisen, insbesondere zweite Rasthaken umfassende zweite Haltemittel aufweisen, die ausgebildet sind, das Lichtführungsbauteil formschlüssig und/oder kraftschlüssig an dem Befestigungsrahmen wahlweise in der ersten Montageposition oder in der zweiten Montageposition zu befestigen.

Die Eingabevorrichtung kann einen flexiblen Träger aufweisen, an dem das wenigstens eine Eingabemittel angeordnet ist, wobei der flexible Träger wenigstens eine das wenigstens eine Eingabemittel bildende Sensorfläche aufweist und die wenigstens eine Sensorfläche einem Lichtschacht des Lichtführungsbauteil zugeordnet ist.

Das Eingabemittel kann einen flexiblen Träger aufweisen, das Lichtführungsbauteil kann eine Halteeinrichtung aufweisen, und der flexible Träger kann demgemäß an der Halteeinrichtung durch wenigstens ein form- und/oder kraftschlüssig wirkendes Befestigungsmittel aufgespannt befestigt sein.

Unter einer aufgespannten Befestigung wird insbesondere ein form- und/oder kraftschlüssiges Halten des flexiblen Trägers verstanden, bei dem Zugkräfte auf den flexiblen Träger einwirken, die sich in der Ebene des flexiblen Trägers erstrecken und dadurch den flexiblen Träger zumindest in einer Richtung, vorzugsweise in zwei orthogonalen Richtungen innerhalb der Ebene des flexiblen Trägers strecken, so dass der flexible Träger knickfrei, faltenfrei, wellenfrei und insbesondere plan an der Halteeinrichtung befestigt ist, insbesondere flächig plan auf der Halteeinrichtung aufliegt. Wenn die Halteeinrichtung als ein Lichtführungsbauteil ausgebildet ist, dann kann der flexible Träger knickfrei, faltenfrei, wellenfrei und insbesondere plan auf dem Lichtführungsbauteil befestigt sein. Unter einer aufgespannten Befestigung kann insbesondere verstanden werden, dass der flexible Träger nur randseitig befestigt ist und in einem mittleren Abschnitt unverbunden auf der Halteeinrichtung bzw. dem Lichtführungsbauteil aufliegt.

Das Befestigungsmittel kann zum wiederholten, zerstörungsfreien Lösen des flexiblen Trägers von der Halteeinrichtung und/oder zum Wiederbefestigen des flexiblen Trägers an der Halteeinrichtung ausgebildet sein.

Die Eingabevorrichtung, die den flexiblen Träger aufweist, an dem das wenigstens eine Eingabemittel angeordnet ist, kann einen Touch-Screen aufweist, der flexible Träger kann eine Sensorfläche des Touch-Screens bilden und das wenigstens eine Eingabemittel kann von einem Flächenbereich der Sensorfläche, insbesondere einem dem jeweiligen Lichtschacht des Lichtführungsbauteils zugeordneten Flächenbereich der Sensorfläche gebildet werden.

Die Bedien- und Anzeigevorrichtung kann außerdem eine Träger-Kodiervorrichtung aufweisen, die ausgebildet ist, eine funktionstüchtige Montage des flexiblen Trägers nur in der ersten Ausführungsart am Lichtführungsbauteil zuzulassen und eine funktionstüchtige Montage eines flexiblen Trägers einer zweiten Ausführungsart am Lichtführungsbauteil zu verhindern. Die Träger-Kodiervorrichtung kann demgemäß ausgebildet sein, nur den flexiblen Träger der Eingabevorrichtung der ersten Ausführungsart an dem Lichtführungsbauteil der ersten Ausführungsart befestigen zu können. Eine andere Träger-Kodiervorrichtung kann demgemäß ausgebildet sein, nur den flexiblen Träger der Eingabevorrichtung der zweiten Ausführungsart an dem Lichtführungsbauteil der zweiten Ausführungsart befestigen zu können. Die unterschiedlichen Ausführungsarten von Lichtführungsbauteilen können sich durch unterschiedliche Anzahl, Größe, Form und/oder Position der Lichtschächte kennzeichnen. Die unterschiedlichen Ausführungsarten von flexiblen Trägern können sich durch unterschiedliche Anzahl, Größe, Form und/oder Position der Eingabemittel kennzeichnen. Die Träger-Kodiervorrichtung kann von korrespondierenden Paaren von Vorsprüngen und Rücksprüngen, insbesondere Aussparungen oder Öffnungen an dem Lichtführungsbauteil einerseits und an dem flexiblen Träger andererseits gebildet werden.

Die Erfindung betrifft außerdem ein Kältegerät, aufweisend eine Bedien- und Anzeigevorrichtung nach einer oder mehreren Ausführungen, wie beschrieben.

Verschiedene konkrete Ausführungsbeispiele von Eingabevorrichtungen sind in der nachfolgenden Beschreibung unter Bezugnahme auf die beigefügten Figuren näher erläutert. Konkrete Merkmale dieser Ausführungsbeispiele können unabhängig davon, in welchem Zusammenhang sie erwähnt sind, gegebenenfalls auch einzeln oder in Kombination betrachtet, allgemeine Merkmale der Erfindung darstellen.

Es zeigen:
- Fig. 1: eine perspektivische Darstellung eines Haushaltsgerät in Bauart eines Kältegeräts mit einem Türblatt, das eine Eingabevorrichtung aufweist,
- Fig. 2a: eine Explosionsdarstellung einer Eingabevorrichtung,
- Fig. 2b: die Eingabevorrichtung gemäß Fig. 2a mit einem aufgespannten flexiblen Träger,
- Fig. 3: eine Explosionsdarstellung einer ersten Ausführungsform einer Eingabevorrichtung, die an einer transparenten Bedienblende aus Kunststoff zu befestigen ist,
- Fig. 4: eine Explosionsdarstellung einer zweiten Ausführungsform einer Eingabevorrichtung, die an einem Befestigungsrahmen aus Kunststoff zu befestigen ist, der an eine Rückseite eines Glastürblatts anzusetzen ist,
- Fig. 5a: eine perspektivische Ansicht von oben auf einen Befestigungsrahmen,
- Fig. 5b: eine perspektivische Ansicht von unten auf den Befestigungsrahmen gemäß Fig. 5a mit Keilflächenführungen für eine korrespondierende Klemmvorrichtung,
- Fig. 5c: eine perspektivische Ansicht einer beispielhaften Klemmvorrichtung von oben,
- Fig. 5d: eine Querschnittsansicht der Klemmvorrichtung gemäß Fig. 5c,
- Fig. 6a: einen Längsschnitt durch ein Lichtführungsbauteil,
- Fig. 6b: eine Draufsicht auf das Lichtführungsbauteil gemäß Fig. 6a mit mehreren Lichtschächten,
- Fig. 6c: eine Teilschnittdarstellung durch einen Lichtschacht des Lichtführungsbauteils gemäß Fig. 6a,
- Fig. 6d: einen Querschnitt durch das Lichtführungsbauteil gemäß Fig. 6a mit ersten Rasthaken zur Befestigung einer elektronischen Leiterplatte.

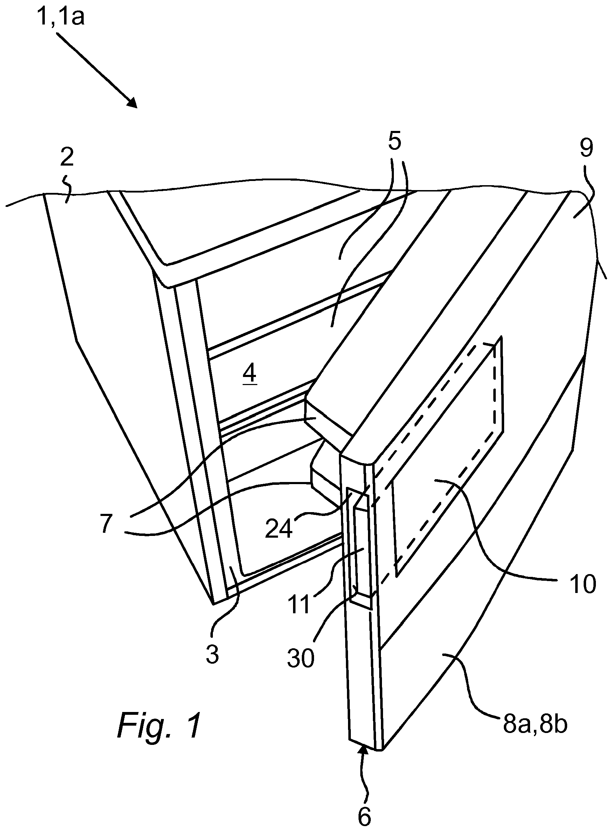

Ein in Fig. 1 beispielhaft dargestelltes Haushaltsgerät 1 ist als ein Kältegerät 1a ausgebildet. Das Kältegerät 1a weist einen Korpus 2 auf. In dem Korpus 2 ist ein wärmeisolierender Innenbehälter 3 angeordnet. Der Innenbehälter 3 begrenzt einen Lagerraum 4 für Kühlgut, insbesondere für Lebensmittel. In dem Innenbehälter 3 können zur Lagerung der Lebensmittel ein oder mehrere Fachböden 5, insbesondere Glasfachböden angeordnet sein. Eine frontseitige Zugangsöffnung des Lagerraums 4 ist durch ein Türblatt 6 verschließbar. Im Falle des vorliegenden Ausführungsbeispiels ist das Türblatt 6 um eine vertikale Schwenkachse schwenkbar bezüglich des Innenbehälters 3 gelagert. Dazu kann das Türblatt 6 durch nicht näher dargestellte Scharnierbeschläge beispielsweise an dem Korpus 2 oder dem Innenbehälter 3 angelenkt sein. An einer dem Lagerraum 4 zugewandten Innenseite des Türblatts 6 können, wie in Fig. 1 dargestellt, ein oder mehrere Türabsteller 7 angeordnet sein. Das Türblatt 6 kann an seiner Außenseite wahlweise eine Glasfront 8a oder eine Metallfront 8b aufweisen. Alternativ oder ergänzend kann das Türblatt außenseitig eine Bedienblende 9 aufweisen. Die Bedienblende 9 kann aus einem Kunststoff hergestellt sein, insbesondere aus einem transparenten Kunststoff hergestellt sein, oder zumindest einen transparenten Fensterabschnitt 10 aufweisen. Der transparente Fensterabschnitt 10 kann in einer speziellen Ausführungsform schon allein durch einen Bereich der Glasfront 8a gebildet werden.

Im Bereich des transparenten Fensterabschnitts 10 weist das Kältegerät 1a eine Eingabevorrichtung 11 auf. Die Eingabevorrichtung 11 ist insbesondere hinter der Bedienblende 9, bzw. der Glasfront 8a oder der Metallfront 8b angeordnet. Die Eingabevorrichtung 11 weist wenigstens ein Eingabemittel 12 auf, das ausgebildet ist, auf Grundlage einer manuellen Betätigung des Eingabemittels 12 eine Funktion des Haushaltsgeräts 1 zu steuern. Im Falle des vorliegenden Ausführungsbeispiels wird das wenigstens eine Eingabemittel 12 von einem Touch-Screen 12a gebildet.

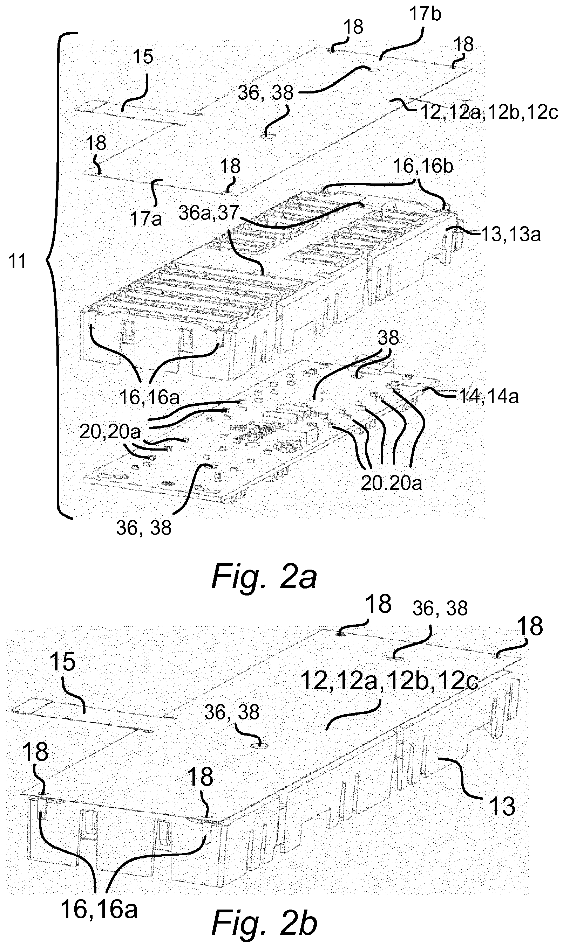

Die Fig. 2a zeigt in einer Explosionsdarstellung einen beispielhaften Aufbau der Eingabevorrichtung 11. Die dortige Eingabevorrichtung 11 umfasst das Eingabemittel 12, insbesondere den Touch-Screen 12a, eine Halteeinrichtung 13 und eine elektronische Steuervorrichtung 14. Die elektronische Steuervorrichtung 14 weist eine elektronische Steuerplatine 14a auf. Die elektronische Steuervorrichtung 14, insbesondere die elektronische Steuerplatine 14a ist ausgebildet, wenigstens eine Funktion des Kältegeräts 1a zu steuern. Dazu ist das wenigstens eine Eingabemittel 12, insbesondere der Touch-Screen 12a über eine elektrische Anschlussleitung 15 elektrisch mit der elektronischen Steuervorrichtung 14, insbesondere der elektronischen Steuerplatine 14a verbunden. Bei manueller Betätigung des Eingabemittels 12 bzw. des Touch-Screens 12a wird über die Anschlussleitung 15 ein zugeordnetes Steuersignal an die Steuerplatine 14a zugeleitet.

Die Eingabevorrichtung 11 weist im Falle des vorliegenden Ausführungsbeispiels also den flexiblen Träger 12b auf, an dem das wenigstens eine Eingabemittel 12 angeordnet ist, und der einen Touch-Screen 12a aufweist, wobei der flexible Träger 12b eine Sensorfläche 12c des Touch-Screens 12a bildet und das wenigstens eine Eingabemittel 12 von einem Flächenbereich der Sensorfläche 12c gebildet wird.

Die Eingabevorrichtung 11, insbesondere das Eingabemittel 12 bzw. der Touch-Screen 12a weist demgemäß einen flexiblen Träger 12b auf. Dies bedeutet, dass der flexible Träger 12b das wenigstens eine Eingabemittel 12 aufweist. Im Falle eines Touch-Screens 12a ist der flexible Träger 12b als eine Touch-Folie ausgebildet, welche die Sensorfläche 12c bildet, die nicht nur eine manuelle Berührung detektieren kann, sondern auch ein Signal liefert über die Stelle, an welcher das manuelle Berühren stattfindet.

Der flexible Träger 12b an der Halteeinrichtung 13 durch wenigstens ein form- und/oder kraftschlüssig wirkendes, mit der Halteeinrichtung 13 verbundenes Befestigungsmittel 16 aufgespannt befestigt.

Das Befestigungsmittel 16 ist zum wiederholten, zerstörungsfreien Lösen des flexiblen Trägers 12b von der Halteeinrichtung 13 und zum Wiederbefestigen des flexiblen Trägers 12b an der Halteeinrichtung 13 ausgebildet.

Dazu weist im Falle des vorliegend dargestellten Ausführungsbeispiels die Halteeinrichtung 13 wenigstens ein starres, insbesondere zwei voneinander beabstandete starre Befestigungsmittel 16a auf, welche ausgebildet sind, einen ersten Endabschnitt 17a des flexiblen Trägers 12b festzuhalten und außerdem wenigstens ein federndes, insbesondere zwei voneinander beabstandete federnde Befestigungsmittel 16b auf, welche ausgebildet sind, einen dem ersten Endabschnitt 17a gegenüberliegenden zweiten Endabschnitt 17b des flexiblen Trägers 12b festzuhalten.

Die starren Befestigungsmittel 16a werden im Falle des vorliegenden Ausführungsbeispiels von zwei an der Halteeinrichtung 13 angeformten, nach oben vorspringenden starren Zapfen gebildet. Jedem starren Zapfen der Halteeinrichtung 13 ist eine kreisförmiges, ein ovales oder längliches Loch 18 in dem flexiblen Träger 12b zugeordnet. An einem den starren Befestigungsmitteln 16a gegenüberliegenden Stirnende der Halteeinrichtung 13 sind zwei federnde Befestigungsmittel 16b an der Halteeinrichtung 13 angeformt. Die federnden Befestigungsmittel 16b werden von zwei an der Halteeinrichtung 13 angeformten, nach oben vorspringenden elastischen Zapfen gebildet. Jedem elastischen Zapfen der Halteeinrichtung 13 ist eine kreisförmiges, ein ovales oder längliches Loch 18 in dem flexiblen Träger 12b zugeordnet. In der aufgespannten Montageanordnung durchdringen jeder starre und elastische Zapfen jeweils eines der Löcher 18 formschlüssig. Aufgrund der federnden bzw. elastischen Ausbildung der federnden Befestigungsmittel 16b, insbesondere der elastischen Zapfen wird der aufgespannte flexible Träger 12b mit einer in der Ebene des flexiblen Trägers 12b wirkenden Zugkraft beaufschlagt, so dass sich der flexible Träger 12b sehr eben ausgerichtet auf der Oberseite der Halteeinrichtung 13 erstreckt. Aufgrund der formschlüssigen Verbindung der starren und elastischen Zapfen mit jeweils eines der Löcher 18 kann der flexible Träger 12b wiederholt zerstörungsfrei von der Halteeinrichtung 13 gelöst und jederzeit wieder an der Halteeinrichtung 13 befestigt werden bzw. durch einen anderen flexiblen Träger 12b ersetzt werden. So ist beispielsweise ein Ersetzen einer defekten Touch-Folie durch eine neue, funktionsfähige Touch-Folie auf eine einfache Weise möglich. Insbesondere kann eine bereits montierte Touch-Folie zerstörungsfrei von der Halteeinrichtung 13 entfernt werden.

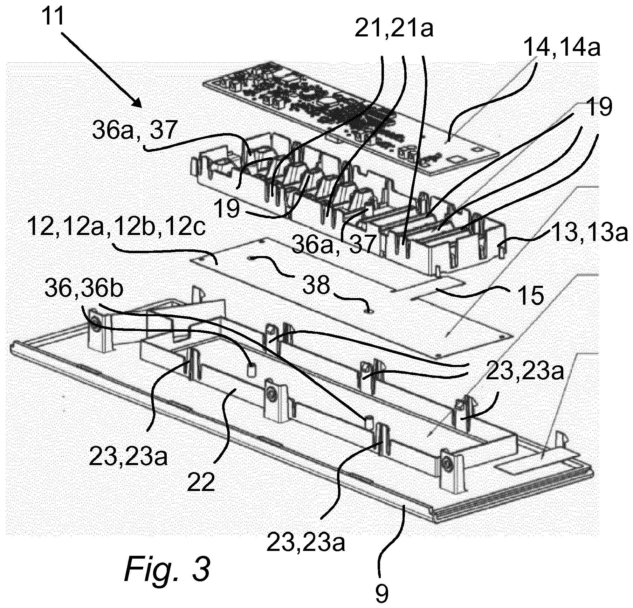

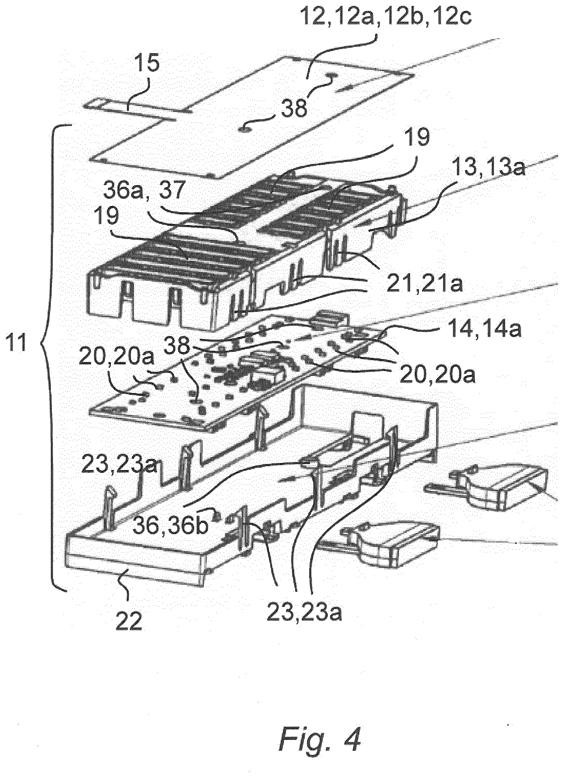

Im Falle der Ausführungsbeispiele, insbesondere gemäß Fig. 3 und Fig. 4, ist die Halteeinrichtung 13 an einem Lichtführungsbauteil 13a ausgebildet, bzw. es wird die Halteeinrichtung 13 durch ein Lichtführungsbauteil 13a gebildet. Das Lichtführungsbauteil 13a weist dabei ein oder mehrere Lichtschächte 19 auf, die ausgebildet sind, das aus wenigstens einem lichtaussendenden elektrischen Bauteil 20, beispielsweise wenigstens einer LED 20a, insbesondere einer auf der elektronischen Steuerplatine 14a bestückten LED 20a ausgesendete Licht an eine Rückseite des flexiblen Trägers 12b zu leiten. Die Halteeinrichtung 13 bzw. das Lichtführungsbauteil 13a kann demgemäß aus einem transparenten Kunststoffbauteil, insbesondere Kunststoffspritzgussbauteil hergestellt sein.

Neben den insoweit an der Halteeinrichtung 13 angeformten Lichtschächte 19 können weitere, auch separate Lichtschächte 19 vorgesehen sein, wie dies in der Fig. 4 gezeigt ist.

Außerdem weist das Lichtführungsbauteil 13a erste Haltemittel 21 auf, die ausgebildet sind, die elektronische Leiterplatte 14a formschlüssig an dem Lichtführungsbauteil 13a zu befestigen. Jedes erste Haltemittel 21 wird im Falle der vorliegenden Ausführungsbeispiele von einem ersten Rasthaken 21a gebildet. Jeder Rasthaken 21a ist einteilig mit dem Lichtführungsbauteil 13a ausgebildet und umfasst einen federnden Schaftabschnitt und eine am freien Ende des federnden Schaftabschnitts angeordnete Rastnase. In einem zusammengebauten Zustand umgreifen die Rasthaken 21a, insbesondere die Rastnasen zugeordnete Randabschnitte der elektronischen Leiterplatte 14a formschlüssig. Insoweit kann die elektronische Leiterplatte 14a an das Lichtführungsbauteil 13a angerastet werden.

Das in den dargestellten Ausführungsvarianten formschlüssig wirkende Kodiermittel kann demgemäß beispielsweise durch zwei Vorsprünge 37 und entsprechenden zwei Aussparung 38 gebildet werden. Die Kodiervorrichtung 36 kann demgemäß derart ausgebildet sein, dass die Vorsprünge 37 und die Aussparungen 38 in der korrekten Montageposition der funktional zugehörigen Bauteile von Eingabemittel 12, Steuerplatine 14a und Lichtführungsbauteil 13a formschlüssig ineinandergreifen. Funktional nicht zugehörige Bauteile von Eingabemittel 12, Steuerplatine 14a und Lichtführungsbauteil 13a würden andererseits formschlüssig nicht ineinandergreifen können, insbesondere die demgemäß falsch angeordneten bzw. falsch ausgebildeten Vorsprünge 37 würden gegen nichtausgesparte Flächen von Eingabemittel 12, Steuerplatine 14a und/oder Lichtführungsbauteil 13a stoßen und dadurch eine Montage verhindern.

In einer ersten Ausführungsvariante gemäß Fig. 3 weist das Kältegerät 1a eine Bedienblende 9 und einen Befestigungsrahmen 22 auf. Der Befestigungsrahmen 22 ist in dieser Ausführungsvariante an einer Rückseite der Bedienblende 9 angeordnet, insbesondere einteilig mit dieser Bedienblende 9 ausgebildet. Mittels des Befestigungsrahmens 22 wird die Baugruppe der Eingabevorrichtung 11, umfassen wenigstens das Eingabemittel 12 bzw. der flexible Träger 12b, insbesondere den Touch-Screen 12a, die Halteeinrichtung 13 bzw. das Lichtführungsbauteil 13a und die elektronische Steuerplatine 14a, an der Rückseite der Bedienblende 9 formschlüssig befestigt.

Dazu weist der Befestigungsrahmen 22 zweite Haltemittel 23 auf, die ausgebildet sind, das Lichtführungsbauteil 13a und damit die Baugruppe der Eingabevorrichtung 11, umfassen wenigstens das Eingabemittel 12 bzw. der flexible Träger 12b, insbesondere den Touch-Screen 12a, die Halteeinrichtung 13 bzw. das Lichtführungsbauteil 13a und die elektronische Steuerplatine 14a, an dem Befestigungsrahmen 22 zu befestigen. Jedes zweite Haltemittel 23 ist im Falle des vorliegenden Ausführungsbeispiels als ein zweiter Rasthaken 23a ausgebildet. Jeder Rasthaken 23a ist einteilig mit dem Befestigungsrahmen 22 ausgebildet und umfasst einen federnden Schaftabschnitt und eine am freien Ende des federnden Schaftabschnitts angeordnete Rastnase. In einem zusammengebauten Zustand umgreifen die zweiten Rasthaken 23a, insbesondere die Rastnasen zugeordnete Randabschnitte des Lichtführungsbauteils 13a formschlüssig. Insoweit kann das Lichtführungsbauteil 13a bzw. die gesamte vormontierte Eingabevorrichtung 11 an den Befestigungsrahmen 22 und damit auch an die Bedienblende 9 angerastet werden.

In einer zweiten Ausführungsvariante gemäß Fig. 4, welche im Wesentlichen mit der Ausführung gemäß Fig. 3 übereinstimmt, ist der Befestigungsrahmen 22 jedoch nicht einteilig mit einer Bedienblende 9 ausgebildet, sondern der Befestigungsrahmen 22 ist als ein separates Bauteil, d.h. als ein von der Bedienblende 9 separates Bauteil ausgeführt.

In einer solchen zweiten Ausführungsvariante gemäß Fig. 4 kann der Befestigungsrahmen 22 an einer Rückseite einer Glasfrontscheibe, insbesondere an der Rückseite eines Glastürblatts des Kältegeräts 1a angeordnet werden.

Dazu kann, wie in Fig. 1 schematisch gezeigt, hinter der Rückseite der Glasfrontscheibe, d.h. der Glasfront 8a bzw. an der Rückseite des Glastürblatts des Haushaltsgeräts 1 bzw. des Kältegeräts 1a ein Schacht 24 vorgesehen sein, in welchen die vormontierte Eingabevorrichtung 11 (Fig. 2b) eingeschoben und dort derart befestigt werden kann, dass der aufgespannte flexible Träger 12b, insbesondere der Touch-Screen 12a an der Rückseite der Glasfrontscheibe, d.h. der Glasfront 8a bzw. an der Rückseite des Glastürblatts flächig anliegt.

Um die vormontierte Eingabevorrichtung 11 (Fig. 2b) an der Rückseite der Glasfrontscheibe, d.h. der Glasfront 8a bzw. an der Rückseite des Glastürblatts flächig anliegend zu befestigen, kann eine Klemmvorrichtung 25 vorgesehen sein, welche ausgebildet ist, in einer in den Schacht 24 eingeschobenen Position sich zwischen der Rückseite der vormontierten Eingabevorrichtung 11 (Fig. 2b) und einer Innenwand des Schachtes 24 einzuspreizen, so dass die Eingabevorrichtung 11 gegen die Rückseite der Glasfrontscheibe, d.h. der Glasfront 8a bzw. an der Rückseite des Glastürblatts gedrückt wird.

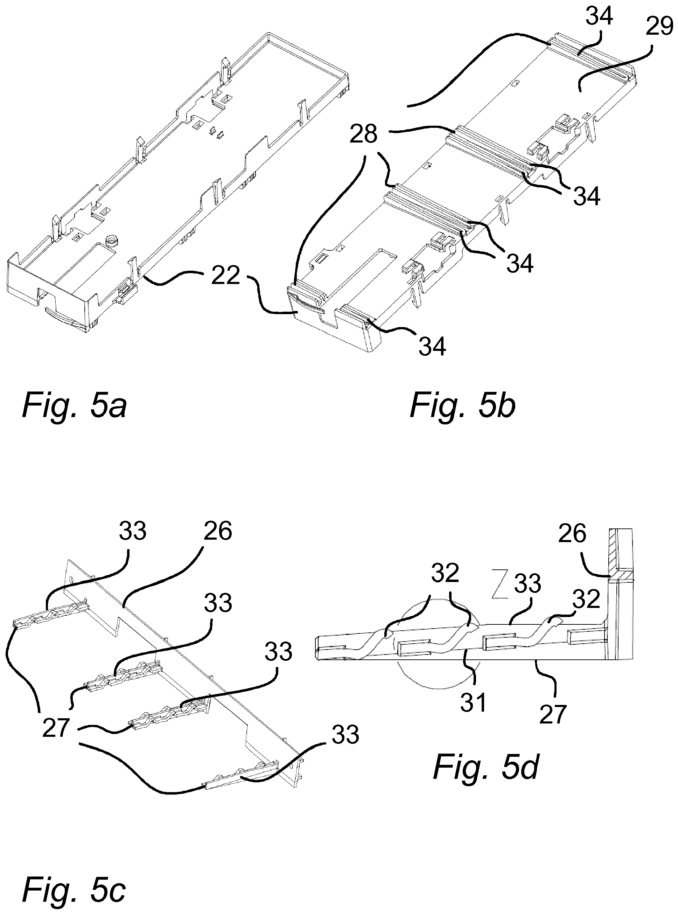

Eine derartige beispielhafte Klemmvorrichtung 25 ist in Fig. 5c und Fig. 5d näher dargestellt. Die Klemmvorrichtung 25 weist im Falle des vorliegenden Ausführungsbeispiels eine Stirnplatte 26 und vier Zinken 27 auf. Die Stirnplatte 26 ist zur Verbindung und gemeinsamen Halterung der Zinken 27 ausgebildet. Die Stirnplatte 26 kann zudem eine Art griffabschnitt bilden, der manuell gegriffen werden kann, um die vier Zinken 27 gemeinsam in den Schacht 24 (Fig. 1) einführen und darin arretieren zu können. Die vier Zinken 27 erstrecken sich in Abständen voneinander und sind parallel zueinander ausgerichtet und an der Stirnplatte 26 befestigt, insbesondere einteilig mit der Stirnplatte 26 ausgebildet.

Jeder Zinken 27 bildet einen Keil. Jeder Keil wirkt in der Einbaulage der Klemmvorrichtung 25 mit schräg verlaufenden Rampen 28 zusammen, die an einer rückseitigen Bodenfläche 29 des Befestigungsrahmens 22 (Fig. 4) angeordnet sind. Indem die Zinken 27 seitlich unter die rückseitigen Bodenfläche 29 des Befestigungsrahmens 22 geschoben werden und sich die Klemmvorrichtung 25 in der Einbaulage gegen eine Rückwand 30 des Schachtes 24 (Fig. 1) abstützt, wird durch das Einschieben der Klemmvorrichtung 25 der Befestigungsrahmen 22 gegen die Rückseite der Glasfrontscheibe, d.h. der Glasfront 8a bzw. gegen die Rückseite des Glastürblatts gedrückt.

Jeder Zinken 27 weist dazu eine schräg verlaufende Tragebene 31 auf, an der drei in Längserstreckung der Zinken 27 hintereinander in gleichmäßigen Abständen voneinander angeordnete Federzungen 32 festgelegt sind. Die Federzungen 32 werden beim Einschieben der Klemmvorrichtung 25 in den Schacht 24 (Fig. 1) elastisch vorgespannt und drücken in der endgültigen Einbaulage den Befestigungsrahmen 22 gegen die Rückseite der Glasfrontscheibe, d.h. der Glasfront 8a bzw. gegen die Rückseite des Glastürblatts. Die Federzungen 32 stützen sich dabei an den schräg verlaufenden Rampen 28 des Befestigungsrahmens 22 ab.

Um das Einschieben der Klemmvorrichtung 25 entlang der Rückseite des Befestigungsrahmens 22 zu erleichtern und ein Verkanten und/oder Verklemmen zu verhindern, weist jeder Zinken 27 eine Führungsleiste 33 auf. Jede Führungsleiste 33 erstreckt sich in Längsrichtung des Zinkens 27, welche gleichzeitig auch die Einschubrichtung ist. Alle Führungsleisten 33 erstrecken sich parallel zueinander. Jeder Führungsleiste 33 ist eine korrespondierende Führungsnut 34 zugeordnet. Die Führungsnuten 34 sind an der Rückseite des Befestigungsrahmens 22 angeordnet, insbesondere einteilig mit diesem ausgebildet. Die Führungsnuten 34 sind im Falle des vorliegenden Ausführungsbeispiels entlang der schräg verlaufenden Rampen 28 des Befestigungsrahmens 22 angeordnet bzw. einteilig mit diesen ausgebildet. Während des Einschiebens der Klemmvorrichtung 25 in den Schacht 24 gleiten die Führungsleisten 33 in den Führungsnuten 34.

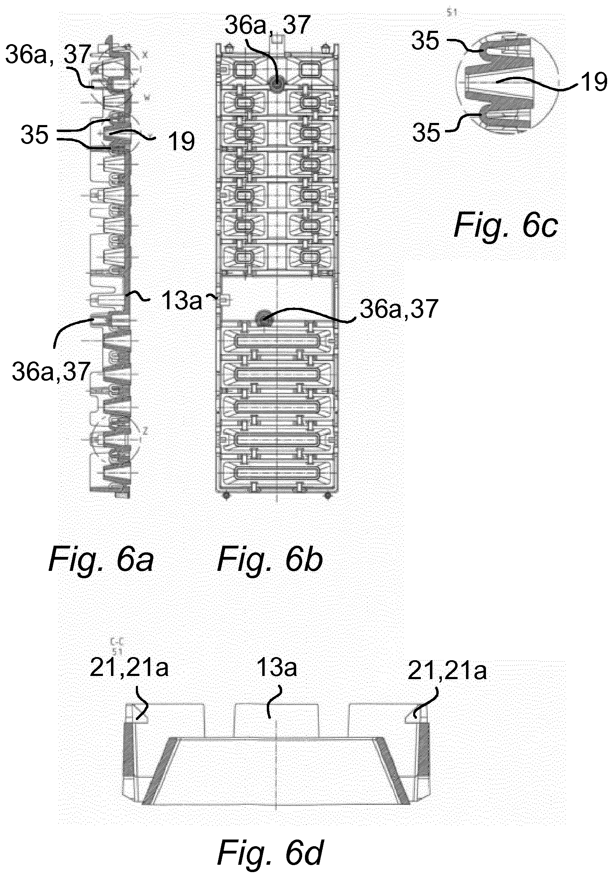

Wie in Fig. 6a bis Fig. 6d dargestellt, kann das Lichtführungsbauteil 13a eine oder mehrere Lichtschächte 19 aufweisen. Um eine zusätzliche Anpresskraft aufzubringen, welche den flexiblen Träger 12b möglichst flächig gegen die Rückseite der Bedienblende 9, die Rückseite der Glasfrontscheibe, d.h. der Glasfront 8a bzw. gegen die Rückseite des Glastürblatts drückt, ist im Falle des vorliegenden Ausführungsbeispiels jeder Lichtschacht 19 federnd an dem Lichtführungsbauteil 13a gelagert, derart, dass in einer hinter der Bedienblende 9, hinter der Glasfrontscheibe, d.h. der Glasfront 8a oder hinter dem Glastürblatt montierten Anordnung der Eingabevorrichtung 11, insbesondere des Lichtführungsbauteils 13a, der auf der Halteeinrichtung 13, insbesondere auf dem Lichtführungsbauteil 13a aufgespannte flexible Träger 12b durch die federnd gelagerten Lichtschächte 19 gegen die Rückseite der Bedienblende 9, der Glasfrontscheibe, d.h. der Glasfront 8a oder des Glastürblatts gedrückt wird.

Zur federnden Lagerung der Lichtschächte 19 an dem Lichtführungsbauteil 13a können elastische Stegabschnitte 35 vorgesehen sein, welche jeden einzelnen Lichtschacht 19 elastisch mit dem Lichtführungsbauteil 13a verbindet. Jeder Stegabschnitt 35 kann S-förmig verlaufend, den jeweiligen Lichtschacht 19 mit dem Lichtführungsbauteil 13a verbinden. Die Stegabschnitt 35, die Lichtschächte 19 und das Lichtführungsbauteil 13a können als ein einstückiges Kunststoffspritzgussteil hergestellt sein.

### BEZUGSZEICHENLISTE

- 1: Haushaltsgerät
- 1a: Kältegerät
- 2: Korpus
- 3: Innenbehälter
- 4: Lagerraum
- 5: Fachboden
- 6: Türblatt
- 7: Türabsteller
- 8a: Glasfront
- 8b: Metallfront
- 9: Bedienblende
- 10: Fensterabschnitt
- 11: Eingabevorrichtung
- 12: Eingabemittel
- 12a: Touch-Screen
- 12b: flexibler Träger
- 12c: Sensorfläche
- 13: Halteeinrichtung
- 13a: Lichtführungsbauteil
- 14: Steuervorrichtung
- 14a: Steuerplatine
- 15: Anschlussleitung
- 16: Befestigungsmittel
- 16a: starres Befestigungsmittel
- 16b: federndes Befestigungsmittel
- 17a: erster Endabschnitt
- 17b: zweiter Endabschnitt
- 18: Löcher
- 19: Lichtschacht
- 20: lichtaussendendes elektrisches Bauteil
- 20a: LED
- 21: erste Haltemittel
- 21a: erste Rasthaken
- 22: Befestigungsrahmen
- 23: zweite Haltemittel
- 23a: zweite Rasthaken
- 24: Schacht
- 25: Klemmvorrichtung
- 26: Stirnplatte
- 27: Zinken
- 28: Rampen
- 29: Bodenfläche
- 30: Rückwand
- 31: Tragebene
- 32: Federzunge
- 33: Führungsleisten
- 34: Führungsnuten
- 35: Stegabschnitte
- 36: Kodiervorrichtung
- 36a: Kodierglied
- 36b: Gegenkodierglied
- 37: Vorsprung
- 38: Aussparung

## Patentansprüche

1. Bedien- und Anzeigevorrichtung für ein Kältegerät (1a), aufweisend:
- eine Bedienblende (9), welche mehrere Betätigungs- und/oder Anzeigefelder einer spezifischen Ausführungsart aufweist,
- eine Eingabevorrichtung (11) mit
∘ mehreren der spezifischen Ausführungsart der Bedienblende (9) angepassten, den Betätigungsfeldern zugeordneten Eingabemitteln (12),
∘ einer elektronischen Steuervorrichtung (14), die ausgebildet ist, wenigstens eine Funktion des Kältegeräts (1a) zu steuern, und die eine elektronische Steuerplatine (14a) aufweist, die wenigstens ein lichtaussendendes elektrisches Bauteil (20) trägt und die ausgebildet ist, basierend auf einer manuellen Betätigung des jeweiligen Betätigungsfeldes der Bedienblende (9) mittels des zugeordneten Eingabemittels (12) der Eingabevorrichtung (11) ein entsprechendes Steuersignal zum Ansteuern der Funktion des Kältegeräts (1a) zu erzeugen, und
o einem Lichtführungsbauteil (13a), das die Eingabevorrichtung (11) trägt und das der spezifischen Ausführungsart von Betätigungs- und/oder Anzeigefeldern der Bedienblende (9) entsprechend ausgebildet ist, das von dem wenigstens einen lichtaussendenden elektrischen Bauteil (20) ausgesendete Licht im Bereich wenigstens eines der Anzeigefelder der Bedienblende (9) an eine Rückseite der Eingabevorrichtung (11) zu leiten, und
- einen Befestigungsrahmen (22), der ausgebildet ist, das entsprechend der spezifischen Ausführungsart ausgebildete Lichtführungsbauteil (13a) an einer Rückseite der Bedienblende (9) derart zu befestigen, dass die Eingabevorrichtung (11) der spezifischen Ausführungsart von Betätigungs- und/oder Anzeigefeldern der Bedienblende (9) entsprechend an die Bedienblende (9) angekoppelt ist,
**gekennzeichnet durch** eine mechanische Kodiervorrichtung (36), die wenigstens ein am Lichtführungsbauteil (13a) ausgebildetes Kodierglied (36a) und wenigstens ein zugeordnetes, an dem Befestigungsrahmen (22) ausgebildetes Gegenkodierglied (36b) aufweist, wobei die Anzahl, Größe, Form und/oder Position des wenigstens einen Kodierglieds (36a) und des wenigstens einen Gegenkodierglieds (36b) ausgebildet sind, eine Montage des Lichtführungsbauteils (13a) nur in einer ersten Montageposition am Befestigungsrahmen (22) zuzulassen,
und wobei der Befestigungsrahmen (22) ferner dazu ausgebildet ist, nur in einer von der ersten Montageposition abweichenden zweiten Montageposition am Befestigungsrahmen (22) wahlweise eine Montage eines entsprechend einer anderen Ausführungsart ausgebildeten anderen Lichtführungsbauteils zuzulassen.

2. Bedien- und Anzeigevorrichtung nach Anspruch 1, **dadurch gekennzeichnet, dass** die Kodiervorrichtung (36) mindestens ein formschlüssig wirkendes Kodiermittel aufweist, insbesondere das Kodierglied (36a) von wenigstens einem Vorsprung (37) und das Gegenkodierglied (36b) von wenigstens einer den Vorsprung (37) in der Montageposition aufnehmenden Aussparung (38) gebildet wird.

3. Bedien- und Anzeigevorrichtung nach einem der Ansprüche 1 bis 2, **dadurch gekennzeichnet, dass** der Befestigungsrahmen (22) an einer Rückseite der Bedienblende (9) befestigt ist, insbesondere als Kunststoffspritzgussteil einteilig mit einer aus Kunststoff hergestellten Bedienblende (9) ausgebildet ist.

4. Bedien- und Anzeigevorrichtung nach einem der Ansprüche 1 bis 2, **dadurch gekennzeichnet, dass** die Bedienblende eine Glasfront aufweist und der Befestigungsrahmen (22) als ein separates Bauteil an einer Rückseite der Glasfront der Bedienblende (9) befestigt ist.

5. Bedien- und Anzeigevorrichtung nach einem der Ansprüche 1 bis 4, **dadurch gekennzeichnet, dass** das Lichtführungsbauteil (13a) ein oder mehrere Lichtschächte (19) aufweist, die der spezifischen Ausführungsart entsprechend in Anzahl, Größe, Form und/oder Position an dem Lichtführungsbauteil (13a) angeordnet sind.

6. Bedien- und Anzeigevorrichtung nach einem der Ansprüche 1 bis 5, **dadurch gekennzeichnet, dass** das Lichtführungsbauteil (13a) erste Haltemittel (21) aufweist, insbesondere erste Rasthaken (21a) umfassende erste Haltmittel (21) aufweist, die ausgebildet sind, die elektronische Steuerplatine (14a) formschlüssig und/oder kraftschlüssig an dem Lichtführungsbauteil (13a) wahlweise in der ersten Montageposition oder in der zweiten Montageposition zu befestigen.

7. Bedien- und Anzeigevorrichtung nach einem der Ansprüche 1 bis 6, **dadurch gekennzeichnet, dass** der Befestigungsrahmen (22) zweite Haltemittel (23) aufweist, insbesondere zweite Rasthaken (23a) umfassende zweite Haltemittel (23) aufweist, die ausgebildet sind, das Lichtführungsbauteil (13a) formschlüssig und/oder kraftschlüssig an dem Befestigungsrahmen (22) wahlweise in der ersten Montageposition oder in der zweiten Montageposition zu befestigen.

8. Bedien- und Anzeigevorrichtung nach einem der Ansprüche 1 bis 7, **dadurch gekennzeichnet, dass** die Eingabevorrichtung (11) einen flexiblen Träger (12b) aufweist, an dem das wenigstens eine Eingabemittel (12) angeordnet ist, der flexible Träger (12b) wenigstens eine das wenigstens eine Eingabemittel (12) bildende Sensorfläche (12c) aufweist, und die wenigstens eine Sensorfläche (12c) einem Lichtschacht (19) des Lichtführungsbauteil (13a) zugeordnet ist.

9. Bedien- und Anzeigevorrichtung nach Anspruch 8, **gekennzeichnet durch** eine Träger-Kodiervorrichtung, die ausgebildet ist, eine funktionstüchtige Montage des flexiblen Trägers (12b) nur in der ersten Ausführungsart am Lichtführungsbauteil (13a) zuzulassen und eine funktionstüchtige Montage eines flexiblen Trägers (12b) einer zweiten Ausführungsart am Lichtführungsbauteil (13a) zu verhindern.

10. Kältegerät (1a), aufweisend eine Bedien- und Anzeigevorrichtung nach einem der Ansprüche 1 bis 9.

## Claims

1. Operating and display apparatus for a refrigeration appliance (1a), having:
- an operating panel (9), which has a plurality of actuation and/or display fields of a specific type of embodiment,
- an input apparatus (11) with
∘ a plurality of input means (12) adapted to the specific type of embodiment of the operating panel (9) and assigned to the actuation fields,
∘ an electronic control apparatus (14), which is embodied to control at least one function of the refrigeration appliance (1a), and which has an electronic control board (14a), which carries at least one light-emitting electrical component (20) and which is embodied, based on a manual actuation of the respective actuation field of the operating panel (9) by means of the assigned input means (12) of the input apparatus (11), to generate a corresponding control signal for actuating the function of the refrigeration appliance (1a), and
∘ a light-guiding component (13a), which carries the input apparatus (11) and which, according to the specific type of embodiment of actuation and/or display fields of the operating panel (9), is embodied to conduct the light emitted by the at least one light-emitting electrical component (20) in the region of at least one of the display fields of the operating panel (9) to a rear side of the input apparatus (11), and
- a fastening frame (22), which is embodied to fasten the light-guiding component (13a), embodied according to the specific type of embodiment, to a rear side of the operating panel (9) in such a manner that the input apparatus (11) of the specific type of embodiment of actuation and/or display fields of the operating panel (9) is coupled to the operating panel (9) accordingly,
**characterised by** a mechanical encoding apparatus (36), which has at least one encoding element (36a) embodied on the light-guiding component (13a) and at least one assigned mating encoding element (36b) embodied on the fastening frame (22), wherein the number, size, shape and/or position of the at least one encoding element (36a) and of the at least one mating encoding element (36b) are embodied to only permit assembly of the light-guiding component (13a) in a first assembly position on the fastening frame (22),
and wherein the fastening frame (22) is further embodied, only in a second assembly position on the fastening frame (22) that deviates from the first assembly position, to optionally permit an assembly of another light-guiding component embodied according to another type of embodiment.

2. Operating and display apparatus according to claim 1, **characterised in that** the encoding apparatus (36) has at least one encoding means acting with a positive fit, in particular the encoding element (36a) is formed by at least one protrusion (37) and the mating encoding element (36b) is formed by at least one recess (38) accommodating the protrusion (37) in the assembly position.

3. Operating and display apparatus according to one of claims 1 to 2, **characterised in that** the fastening frame (22) is fastened to a rear side of the operating panel (9), in particular is embodied in one piece with an operating panel (9) made of plastic, as a plastic injection moulded part.

4. Operating and display apparatus according to one of claims 1 to 2, **characterised in that** the operating panel has a glass front and the fastening frame (22) is fastened to a rear side of the glass front of the operating panel (9), as a separate component.

5. Operating and display apparatus according to one of claims 1 to 4, **characterised in that** the light-guiding component (13a) has one or more light shafts (19), which in terms of their number, size, shape and/or position are arranged on the light-guiding component (13a) according to the specific type of embodiment.

6. Operating and display apparatus according to one of claims 1 to 5, **characterised in that** the light-guiding component (13a) has first retaining means (21), in particular first retaining means (21) comprising first latching hooks (21a), which are embodied to optionally fasten the electronic control board (14a) to the light-guiding component (13a) with a positive fit and/or non-positive fit in the first assembly position or in the second assembly position.

7. Operating and display apparatus according to one of claims 1 to 6, **characterised in that** the fastening frame (22) has second retaining means (23), in particular second retaining means (23) comprising second latching hooks (23a), which are embodied to optionally fasten the light-guiding component (13a) to the fastening frame (22) with a positive fit and/or non-positive fit in the first assembly position or in the second assembly position.

8. Operating and display apparatus according to one of claims 1 to 7, **characterised in that** the input apparatus (11) has a flexible carrier (12b), on which the at least one input means (12) is arranged, the flexible carrier (12b) has at least one sensor surface (12c) forming the at least one input means (12), and the at least one sensor surface (12c) is assigned to a light shaft (19) of the light-guiding component (13a).

9. Operating and display apparatus according to claim 8, **characterised by** a carrier encoding apparatus, which is embodied to only permit a functional assembly of the flexible carrier (12b) on the light-guiding component (13a) in the first type of embodiment and to prevent a functional assembly of a flexible carrier (12b) of a second type of embodiment on the light-guiding component (13a).

10. Refrigeration appliance (1a), having an operating and display apparatus according to one of claims 1 to 9.

## Revendications

1. Dispositif de commande et d'affichage pour un appareil frigorifique (1a), présentant :
- un bandeau de commande (9), qui présente plusieurs champs d'actionnement et/ou d'affichage d'un mode d'exécution spécifique,
- un dispositif de saisie (11) avec
∘ plusieurs moyens de saisie (12) adaptés au mode d'exécution spécifique du bandeau de commande (9), affectés aux champs d'actionnement,
∘ un dispositif de pilotage électronique (14) formé afin de piloter au moins une fonction de l'appareil frigorifique (1a), et qui présente une platine de pilotage électronique (14a) portant au moins un composant électrique émetteur de lumière (20) et formé afin de générer, sur la base d'un actionnement manuel du champ d'actionnement respectif du bandeau de commande (9) au moyen du moyen de saisie affecté (12) du dispositif de saisie (11), un signal de pilotage correspondant pour le pilotage de la fonction de l'appareil frigorifique (1a),
et
∘ un composant de guidage de lumière (13a) qui porte le dispositif de saisie (11) et formé selon le mode d'exécution spécifique de champs d'actionnement et/ou d'affichage du bandeau de commande (9) afin de diriger la lumière émise par l'au moins un composant électrique émetteur de lumière (20) dans la zone d'au moins l'un des champs d'affichage du bandeau de commande (9) sur un côté arrière du dispositif de saisie (11), et
- un cadre de fixation (22) formé afin de fixer de telle sorte sur un côté arrière du bandeau de commande (9) le composant de guidage de lumière (13a) formé selon le mode d'exécution spécifique que le dispositif de saisie (11) est couplé de façon correspondante, selon le mode d'exécution spécifique de champs d'actionnement et/ou d'affichage du bandeau de commande (9), au bandeau de commande (9), **caractérisé par** un dispositif de codage mécanique (36) qui présente au moins un élément de codage (36a) formé sur le composant de guidage de lumière (13a) et au moins un élément de contre-codage (36b) associé formé sur le cadre de fixation (22), dans lequel le nombre, la taille, la forme et/ou la position de l'au moins un élément de codage (36a) et de l'au moins un élément de contre-codage (36b) sont formés afin de permettre un montage du composant de guidage de lumière (13a) uniquement dans une première position de montage sur le cadre de fixation (22), et dans lequel le cadre de fixation (22) est en outre formé afin de permettre uniquement dans une deuxième position de montage sur le cadre de fixation (22) différente de la première position de montage au choix un montage d'un autre composant de guidage de lumière formé selon un autre mode d'exécution.

2. Dispositif de commande et d'affichage selon la revendication 1, **caractérisé en ce que** le dispositif de codage (36) présente au moins un moyen de codage agissant par complémentarité de formes, en particulier l'élément de codage (36a) est formé au départ d'au moins une saillie (37) et l'élément de contre-codage (36b) au départ d'au moins un évidement (38) accueillant la saillie (37) dans la position de montage.

3. Dispositif de commande et d'affichage selon l'une des revendications 1 à 2, **caractérisé en ce que** le cadre de fixation (22) est fixé sur un côté arrière du bandeau de commande (9), en particulier sous forme de pièce en plastique moulée par injection en une seule pièce avec un bandeau de commande (9) fabriqué en plastique.

4. Dispositif de commande et d'affichage selon l'une des revendications 1 à 2, **caractérisé en ce que** le bandeau de commande présente une partie avant en verre et le cadre de fixation (22) est fixé sous la forme d'un composant séparé sur un côté arrière de la partie avant en verre du bandeau de commande (9).

5. Dispositif de commande et d'affichage selon l'une des revendications 1 à 4, **caractérisé en ce que** le composant de guidage de lumière (13a) présente un ou plusieurs puits de lumière (19), disposés selon le mode d'exécution spécifique en termes de nombre, taille, forme et/ou position sur le composant de guidage de lumière (13a).

6. Dispositif de commande et d'affichage selon l'une des revendications 1 à 5, **caractérisé en ce que** le composant de guidage de lumière (13a) présente des premiers moyens de retenue (21), en particulier des premiers moyens de retenue (21) comprenant des premiers crochets d'encliquètement (21a), formés afin de fixer la platine de pilotage électronique (14a) par complémentarité de formes et/ou de forces sur le composant de guidage de lumière (13a) au choix dans la première position de montage ou dans la deuxième position de montage.

7. Dispositif de commande et d'affichage selon l'une des revendications 1 à 6, **caractérisé en ce que** le cadre de fixation (22) présente des deuxièmes moyens de retenue (23), en particulier des deuxièmes moyens de retenue (23) comprenant des deuxièmes crochets d'encliquètement (23a), formés afin de fixer le composant de guidage de lumière (13a) par complémentarité de formes et/ou de forces sur le cadre de fixation (22) au choix dans la première position de montage ou dans la deuxième position de montage.

8. Dispositif de commande et d'affichage selon l'une des revendications 1 à 7, **caractérisé en ce que** le dispositif de saisie (11) présente un support flexible (12b), sur lequel l'au moins un moyen de saisie (12) est disposé, le support flexible (12b) présente au moins une surface de capteurs (12c) formant l'au moins un moyen de saisie (12) et l'au moins une surface de capteurs (12c) est associé à un puits de lumière (19) du composant de guidage de lumière (13a).

9. Dispositif de commande et d'affichage selon la revendication 8, **caractérisé par** un dispositif de codage de support formé afin d'autoriser un montage utilisable du support flexible (12b) uniquement dans le premier mode d'exécution sur le composant de guidage de lumière (13a) et d'empécher un montage utilisable d'un support flexible (12b) d'un deuxième mode d'exécution sur le composant de guidage de lumière (13a).

10. Appareil frigorifique (1a) présentant un dispositif de commande et d'affichage selon l'une des revendications 1 à 9.
